**Europäisches Patentamt**

**European Patent Office**

**Office européen des brevets**

(19)

(11) Veröffentlichungsnummer : **0 461 099 A1**

## (12) EUROPÄISCHE PATENTANMELDUNG

(21) Anmeldenummer : **91890107.5**

(22) Anmeldetag : **15.05.91**

(51) Int. Cl.⁵ : **H01L 23/525, G11C 17/00**

(30) Priorität : **15.05.90 AT 1084/90**

(43) Veröffentlichungstag der Anmeldung :
**11.12.91 Patentblatt 91/50**

(84) Benannte Vertragsstaaten :
**AT BE CH DE DK ES FR GB GR IT LI LU NL SE**

(71) Anmelder : **AUSTRIA MIKRO SYSTEME INTERNATIONAL GESELLSCHAFT m.b.H. (Austria Micro Systems International Gesellschaft m.b.H.)**
**Schloss Premstätten, Tobelbachstrasse**
**A-8141 Unterpremstätten (AT)**

(72) Erfinder : **Unterleitner, Franz, Dipl.-Ing.**
**Hofäckerweg 16**
**A-8401 Kalsdorf (AT)**
Erfinder : **Tschernay, Klaus-Peter, Dipl.-Ing.**
**Marschallgasse 11**
**A-8020 Graz (AT)**

(74) Vertreter : **Haffner, Thomas M., Dr. et al**
**Patentanwaltskanzlei Dipl.-Ing. Adolf Kretschmer Dr. Thomas M. Haffner**
**Schottengasse 3a**
**A-1014 Wien (AT)**

(54) **Nichtflüchtige Halbleiter-Speicherzelle.**

(57) Eine nichtflüchtige Halbleiter-Speicherzelle, insbesondere für integrierte programmierbare Festwertspeicher PROMs), hat eine Leiterbahn (Fuse) (1) aus polykristallinem Silizium, deren elektrische Leitfähigkeit durch Stromdurchgang eines Programmierstromes wesentlich herabgesetzt werden kann. Diese Leiterbahn (1) liegt in Reihe mit der Schaltstrecke eines Halbleiter-Schaltelementes in Form eines hinsichtlich der zum Herabsetzen der Leitfähigkeit der Leiterbahn erforderlichen Programmierstromes unterdimensionierten MOS-FET (11), der auf einem Halbleitersubstrat ausgebildet ist, in welchem sich ein mit dem MOS-FET (11) unmittelbar gekoppelter und unter Programmierbedingungen zusammenwirkender parasitärer lateraler bipolarer Transistor ergibt, der bei Betrieb in einem vorbestimmten, unterhalb der Breakdownspannung liegenden Spannungsbereich unter Ansteuerung durch die Gatespannung über Stoßionisation vom Kanalstrom des MOS-FET (11) in den leitenden Zustand bringbar ist und in diesem Zustand die erforderliche Programmierenergie zu schalten imstande ist, wozu der MOS-FET (11) allein wegen seiner zu kleinen Dimensionierung nicht in der Lage wäre, und nach dem Durchbrennen der Fuse (1) selbsttätig ausschaltet.

FIG. 4

EP 0 461 099 A1

Die Erfindung bezieht sich auf eine nichtflüchtige Halbleiter-Speicherzelle, insbesondere für integrierte programmierbare Festwertspeicher (PROMs), bei welcher die Leitfähigkeit einer Leiterbahn (Fuse), insbesondere aus polykristallinem Silizium, durch Stromdurchgang wesentlich herabgesetzt werden kann, wobei die Leiterbahn in Reihe mit der Schaltstrecke eines Halbleiter-Schaltelementes angeordnet ist.

Für die Herstellung von PROMs ist es bekannt, Fuses unterschiedlichen Typs zu verwenden, deren Leitfähigkeit unter Einwirkung elektrischen Stromes zerstört oder zumindest wesentlich herabgesetzt werden kann. Neben Nickel-Chrom-Fuses und Titan-Wolfram -Fuses sind auch Leiter auf der Basis von Aluminium bekannt, welche unter Einwirkung des elektrischen Stromes beim Programmieren zerstört werden können, worauf bei einem anschließenden Lesevorgang in der entsprechenden Zelle kein Stromfluß detektiert wird.

Neben derartigen metallischen Leitern für die Herstellung von Fuses ist es auch bekannt, polykristalline Siliziumbahnen durch Anwendung elektrischen Stromes in ihrer Leitfähigkeit wesentlich herabzusetzen. Während die Verwendung von metallischen Leiterbahnen die Passivierung, d.h. die den Bauteil umgebende SiO₂-Schicht, nicht beeinträchtigt, wenn derartige Leiterbahnen auf der Oberfläche derartiger Passivierungen angeordnet sind, ist es im Falle der Verwendung von polykristallinem Silizium für derartige Fuses wesentlich, daß die für die Herabsetzung der Leitfähigkeit eingebrachte Energie die Passivierung in keiner Weise beeinträchtigt. Polykristallines Silizium erfordert in der Regel relativ hohe Programmierenergie, welche mit konventionell für das Lesen verwendbaren MOS-Feldeffekttransistoren (MOS-FET) nicht ohne weiteres geschaltet werden kann. Für die Programmierung derartiger, "Polyfuses" auf der Basis von polykristallinem Silizium enthaltender Bauteile ist es daher in der Regel erforderlich, eigene Programmierpads zu verwenden, wobei allerdings die Programmierung nur vor dem Assemblieren erfolgen kann oder ein Gehäuse mit entsprechend vielen gesonderten Anschlüssen gewählt werden muß. Die Programmierung durch Änderung der Leitfähigkeit von polykristallinem Silizium erfordert spezielle Sicherheitsvorkehrungen in bezug auf die Strombegrenzung, um die Passivierung nicht zu gefährden, und anderseits muß eine Stromstärke gewählt werden, welche ausreicht, die gewünschte Veränderung des polykristallinen Siliziums zur Herabsetzung der Leitfähigkeit sicherzustellen. Es ist in diesem Zusammenhang bekannt geworden, mit Stromimpulsen zu arbeiten, und eine größere Anzahl von Stromimpulsen mit einer Impulsdauer von einigen Mikrosekunden über mehrere Millisekunden aufrecht zu erhalten. Die exakte Wahl der Impulsdauer und der Pause ist hiebei insbesondere im Hinblick auf die Gefährdung der Passivierung von besonderer Bedeutung. Nachteilig bei der Verwendung derartiger Leiterbahnen aus polykristallinem Silizium als Material für die Fuses bleibt allerdings der Umstand, daß mit den in integrierten Bauteilen vorgesehenen Halbleiter-Schaltelementen in der Regel die sichere Programmierung nicht gelingt.

Die Erfindung zielt nun darauf ab, eine nichtflüchtige Halbleiter-Speicherzelle der eingangs genannten Art, bei welcher Fuses aus polykristallinem Silizium, nachfolgend kurz Polyfuses genannt, zum Einsatz gelangen, dahingehend weiterzubilden, daß ohne eigene Programmierpads unmittelbar mit den zugeordneten Halbleiter-Schaltelementen nicht nur ein Lesevorgang, sondern auch der Programmierstrom geschaltet werden kann. Zur Lösung dieser Aufgabe besteht die erfindungsgemäße Ausbildung im wesentlichen darin, daß das Halbleiter-Schaltelement von einem hinsichtlich des zum Herabsetzen der Leitfähigkeit der Leiterbahn erforderlichen Programmierstromes unterdimensionierten MOS-FET gebildet ist, der auf einem Halbleitersubstrat ausgebildet ist, in welchem sich ein mit dem MOS-FET unmittelbar gekoppelter und unter Programmierbedingungen zusammenwirkender parasitärer lateraler bipolarer Transistor ergibt. Auf diese Weise können konventionelle und einfache, für die erforderliche Schaltleistung nicht ausreichende MOS-FETs verwendet werden, über welche in der Folge der Lesevorgang ohne weiteres bewerkstelligt werden kann, wobei dadurch, daß ein derartiger MOS-FET auf einem Halbleitersubstrat ausgebildet ist, für die beim Programmieren erforderlichen höheren Ströme zwischen dem MOS-FET und dem Halbleitersubstrat ein zusätzlicher bipolarer Schalttransistor zum Schalten der höheren Programmierströme zur Verfügung steht.

Im besonderen ist der MOS-FET für einen Programmiervorgang mit einer zwischen Snapbackspannung (Vsnp) und Breakdownspannung (Vb) liegenden Senkenspannung betreibbar, wobei bei Stromfluß durch den MOS-FET zusätzlich der parasitäre bipolare Transistor geschaltet wird und der auf diese Weise leitende bipolare Transistor der Schaltstrecke des MOS-FET parallelgeschaltet ist. Mit einem derartigen parallelgeschalteten bipolaren Transistor wird der Umstand genützt, daß unterhalb der Breakdownspannung ein Spannungsbereich zur Verfügung steht, bei dem die Gatespannung am MOS-FET entscheidet, ob der parasitäre bipolare Transistor leitend wird oder nicht. Wird bei geeigneter Gatespannung der MOS-FET leitend, so erzeugt der Kanalstrom über Stoßionisation Ladungsträger, die den parasitären bipolaren Stromfluß anregen. Mit dem erhöhten Gesamtstromfluß erhöht sich die Stoßionisation weiter und verstärkt den bipolaren Einfluß. Durch die Mitkopplung eines derartigen parasitären lateralen bipolaren Transistors läßt sich somit im Programmierbetrieb ein Strom schalten, der für die gewünschte Veränderung der Leitfähigkeit der Fuses ausreicht. Der Lesevorgang findet hiebei in der Regel bei einem gegenüber der Breakdownspannung wesentlich verringerten Spannungsniveau statt.

Polyfuses können entsprechend dem Stand der Technik in einem Layout verwirklicht werden, bei welchem der für das Programmieren relevante Teil der Leiterbahn eine charakteristische Einschnürung bzw. Verengung aufweist, so daß der Ort der Umsetzung der Leistung beim Programmieren auf den Verengungsbereich lokalisiert werden kann. In jedem Fall muß dafür Sorge getragen werden, daß die lokale Erhitzung des Polysiliziums nicht ausreicht, um die Passivierung des Bauteiles zu gefährden. Naturgemäß sind für das Design und Layout derartiger Polyfuses auch andere Parameter von besonderer Bedeutung, wie beispielsweise die Optimierung des Widerstandes und ein ausreichender Kontaktabstand zur Vermeidung der Diffusion von Al-Atomen von einem Kontakt zum anderen Kontakt.

Eine integrierte MOS-Speicherschaltung mit einer Mehrzahl von Speicherzellen der beschriebenen Art ist gemäß der Erfindung zweckmäßig derart ausgebildet, daß mit der Senke (Drain) jedes MOS-FET ein Ende einer Leiterbahn (Fuse) verbunden ist, daß die Quellen (Source) aller MOS-FETs sowie die anderen Enden aller Leiterbahnen mit je einer gemeinsamen Leitung verbunden sind, daß zum einzelnen Ansteuern der Steuerelektroden (Gate) der MOS-FETs ein Adreßdecoder vorgesehen ist und daß die gemeinsame Leitung für alle Leiterbahnen (Fuses) einerseits über einen Widerstand mit einem Pull-up-Element verbunden ist, wobei ein Lese-Signal von diesem Verbindungspunkt über einen Detektor an ein Ausgangs-Pad oder andere integrierte Schaltungsteile gelangt, und anderseits über eine Schutzstruktur gegen elektrostatische Entladungen an ein Programmier-Pad angeschlossen ist. Insgesamt ergibt sich durch eine derartige Anordnung die Möglichkeit, Schalttransistoren kleinster Bauart zu verwenden, wobei nur ein Pad zur Energiezufuhr beim Programmieren erforderlich ist, und wobei die Leistung innerhalb des integrierten Schaltkreises geschaltet werden kann und somit die Programmierung im Gehäuse möglich wird. Die Programmierenergie kann durch entsprechendes Layout soweit reduziert werden, daß eine Beschädigung der Passivierung vermieden wird, wodurch die Zuverlässigkeit des Bauteiles erhalten bleibt. Im einfachsten Fall ist die MOS-Speicherschaltung zu einem PROM der Organisation n x 1 Bit verschaltet, wobei naturgemäß bei entsprechend aufwendigerer Adressierungslogik auch höhere Organisationen, wie beispielsweise n x 8 Bit-Strukturen möglich sind.

Als Pull-up-Element genügt im einfachsten Fall ein ohmscher Widerstand, vorzugsweise wird ein Pull-up-Transistor eingesetzt, der nur für einen Lesevorgang vom Adreßdecoder leitend gesteuert wird.

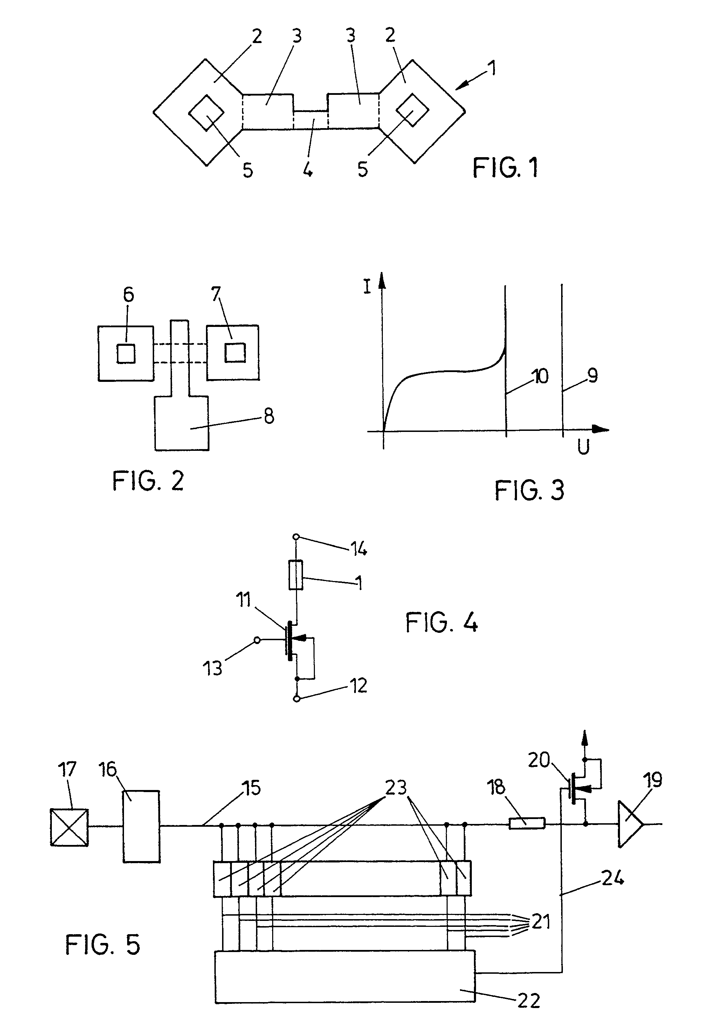

Die Erfindung wird nachfolgend an Hand von in der Zeichnung schematisch dargestellten Ausführungsbeispielen näher erläutert. In dieser zeigt: Fig.1 eine Leiterbahn (Fuse) aus polykristallinem Silizium in Draufsicht; Fig.2 einen MOS-Feldeffekttransistor (MOS-FET) in Draufsicht; Fig.3 eine Senkenstrom-Senkenspannungs-Kennlinie des Feldeffekttransistors von Fig.2; Fig.4 die Zusammenschaltung eines Feldeffekttransistors nach Fig.2 mit einer Leiterbahn aus polykristallinem Silizium nach Fig.1 zu einer Speicherzelle und Fig.5 schematisch eine aus Schaltungskombinationen gemäß Fig.4 zusammengesetzte integrierte MOS-Speicherschaltung.

In Fig.1 ist eine für die erfindungsgemäße nichtflüchtige Halbleiter-Speicherzelle verwendbare Leiterbahn (Fuse) 1 aus polykristallinem Silizium dargestellt, die sich in integrierten Silizium-Halbleiterschaltkreisen in einfacher Weise ausbilden läßt. Die Leiterbahn umfaßt Kontaktbereiche 2, Leitungsbereiche 3 mit einer Einschnürung 4 und in der Mitte jedes Kontaktbereiches 2 eine Kontaktstelle 5. Durch diese Ausgestaltung wird erreicht, daß bei Stromdurchgang durch den Leitungsbereich zwischen den beiden Kontaktbereichen ein Großteil der Leistung im Bereich der Einschnürung 4 umgesetzt wird und es hier zu einer starken lokalen Erhitzung des polykristallinen Siliziums kommt. Dadurch wird die Leiterbahn 1 elektrisch nichtleitend. Kritisch sind dabei auch Länge und Breite des Leitungsbereiches 3, weil gegensätzlichen Forderungen nach minimalem elektrischen Widerstand und ausreichendem Kontaktabstand zur Vermeidung einer Diffusion von Aluminiumatomen von einer Kontaktstelle 5 zu der anderen Kontaktstelle 5 Rechnung getragen werden muß. Bei der Dimensionierung von Länge und Breite der Einschnürung 4 ist zu beachten, daß an dieser Stelle eine möglichst hohe Strom- bzw. Leistungsdichte erzwungen werden soll, wobei aber die Dimensionierung prozeßtechnisch gut reproduzierbar sein muß.

Als Schalttransistor sowohl für die einmalige Programmierung der Leiterbahn 1 als auch für nachfolgende Lesevorgänge wird ein MOS-FET eingesetzt, wie er in Fig.2 schematisch dargestellt ist. Beispielsweise sind zur Bildung eines N-Kanal-MOS-FET vom Anreicherungs(enhancement)-Typ in ein Substrat aus P-leitendem Silizium oder in eine in einem Substrat aus N-leitendem Silizium vorgesehene P-leitende "Wanne" zwei Inseln vom Leitungstyp N+ als quelle 6 und Senke 7 eindiffundiert. Die freie Oberfläche des Halbleitersubstrates ist mit einer isolierenden Schicht aus $SiO_2$ überzogen. Auf der $SiO_2$-Schicht ist eine Steuerelektrode 8 vorgesehen, von der sich ein Teil über den zwischen quelle 6 und Senke 7 befindlichen Bereich erstreckt. Wenn im Fall des N-Kanal-MOS-FET sowohl die Senke 7 als auch die Steuerelektrode 8 bezüglich der quelle 6 ein positives Potential aufweisen, entsteht zwischen quelle und Senke im Bereich der Steuerelektrode 8 unter der SiO₂-Schicht im P-leitenden Siliziumsubstrat durch Influenz ein dinner leitender Kanal mit Elektronen als beweglichen Ladungsträgern. Um störende Widerstände klein zu halten, muß der Abstand der Kontakte von quelle 6 und Senke 7 zur Steuerelektrode 8 möglichst klein gehalten werden. Bedingt durch den Aufbau des MOS-FET ergibt sich in dem ihn umgebenden Halbleitersubstrat bzw. in der Wanne ein mit dem MOS-FET unmittelbar gekoppelter parasitärer lateraler bipolarer Transistor.

Zum Schalten des MOS-FET wird der Snapback-Effekt ausgenützt. Eine wesentliche Kennlinie des Senkenstromes in Abhängigkeit von der zwischen Senke und Quelle anliegenden Gleichspannung bei einer konstanten Spannung zwischen Steuerelektrode und Quelle ist in Fig.3 dargestellt. Die Durchbruchspannung 9 (Breakdownspannung Vb) eines N-Kanal-MOS-FET mit Steuerelektrodenspannung 0 V, bezogen auf das Quellenpotential, ist deutlich höher als die Durchbruchspannung bei einer Steuerelektrodenspannung größer als 0 V. Beim Stromfluß durch den Feldeffekttransistor und hinreichend großer Feldstärke (d.h. Senkenspannung) kommt es zu Stoßionisation und damit zur Ausbildung eines Substratstromes, der den parasitären lateralen bipolaren NPN-Transistor einschaltet. Durch Mitkopplung kommt es zum Durchbruch und der Transistor gerät in einen Bereich geringen differentiellen Widerstandes. Die Senkenspannung, bei der die zum Durchbruch erforderliche kritische Feldstärke erreicht wird, ist die Snapbackspannung Vsnp 10.

Dank der vorerwähnten Eigenschaften eignet sich der MOS-FET als Programmierschalter für eine Leiterbahn aus polykristallinem Silizium. Eine derartige Kombination einer Leiterbahn 1 und eines MOS-FET 11 ist in Fig.4 dargestellt. Diese Kombination stellt eine nichtflüchtige programmierbare 1-Bit-Speicherzelle dar. Im folgenden sind alle Spannungen auf den Quellenknoten 12 des MOS-FET bezogen. Die Durchbruchspannung des MOS-FET 11 läßt sich durch die Spannung der Steuerelektrode (Knoten 13) steuern. Die Programmierspannung (Vprog) am Knoten 14 wird zwischen Snapbackspannung und Breakdownspannung gewählt. Bei Steuerelektrodenspannung 0 V bricht der MOS-FET 11 nicht durch und die Leiterbahn 1 bleibt elektrisch leitend. Wird an den MOS-FET 11 eine Steuerelektrodenspannung größer als 0 V angelegt, so erfolgt ein Durchbruch, weil Vsnp kleiner ist als Vprog, wobei der Strom nur mehr durch die Widerstände im Senkenkreis begrenzt ist und die Einschnürung (4 in Fig.1) der Leiterbahn sich so stark erhitzt, daß diese elektrisch nichtleitend wird, wodurch der Strom durch die Speicherzelle selbsttätig abgeschaltet wird. Zum Lesen programmierter Daten wird der knoten 14 mit einer Betriebsspannung beaufschlagt, die kleiner ist als die Snapbackspannung, und der MOS-FET 11 wird mit einer positiven Steuerelektrodenspannung eingeschaltet. Je nach dem Zustand der Leiterbahn 1 kann dann ein Strom durch die Anordnung fließen oder nicht.

Fig.5 zeigt schematisch eine integrierte MOS-Speicherschaltung mit Speicherzellen gemäß Fig.4 als PROM der Organisation n x 1 Bit. Dabei sind die knoten (14 in Fig.4) aller Speicherzellen mit einer gemeinsamen Leitung 15 (Vprog-Powerbus) verbunden. Dieser Vprog-Powerbus ist über eine Schutzstruktur 16 gegen elektrostatische Entladungen an ein Pad 17 geführt. Weiters führt der Vprog-Powerbus über einen Widerstand 18 an einen Detektor 19 und einen Pull-up-Transistor 20 zur Stromversorgung. Zur Selektion einer bestimmten Speicherzelle sind Steuerleitungen 21 eines Adreßdecoders 22 an die einzelnen Speicherzellen 23 geführt, wobei außerdem eine Steuerleitung 24 für die Aktivierung des Pull-up-Transistors 20 bei einem Lesevorgang vorgesehen ist.

Die erfindungsgemäße Ausbildung ermöglicht eine wesentliche Größenreduktion integrierter programmierbarer Halbleiterspeicher, da nur ein Pad für die Energiezufuhr erforderlich ist und Schalttransistoren kleinster Bauart verwendbar sind, weil der Snapbackeffekt bewußt ausgenützt wird. Die Leistung kann innerhalb des integrierten Schaltkreises geschaltet werden und somit ist eine Programmierung im Gehäuse möglich. Die Programmierenergie ist gering und somit besteht keine Gefahr einer Beschädigung der Passivierung und daraus folgender Zuverlässigkeitsprobleme. Für die Ausbildung der die Information speichernden Leiterbahnen steht polykristallines Silizium in allen MOS-Herstellungsprozessen zur Verfügung.

## Patentansprüche

1. Nichtflüchtige Halbleiter-Speicherzelle, insbesondere für integrierte programmierbare Festwertspeicher (PROMs), bei welcher die Leitfähigkeit einer Leiterbahn (Fuse), insbesondere aus polykristallinem Silizium, durch Stromdurchgang wesentlich herabgesetzt werden kann, wobei die Leiterbahn in Reihe mit der Schaltstrecke eines Halbleiter-Schaltelementes angeordnet ist, dadurch gekennzeichnet, daß das Halbleiter-Schaltelement von einem hinsichtlich des zum Herabsetzen der Leitfähigkeit der Leiterbahn erforderlichen Programmierstromes unterdimensionierten MOS-FET (11) gebildet ist, der auf einem Halbleitersubstrat ausgebildet ist, in welchem sich ein mit dem MOS-FET unmittelbar gekoppelter und unter Programmierbedingungen zusammenwirkender parasitärer lateraler bipolarer Transistor ergibt.

2. Nichtflüchtige Halbleiter-Speicherzelle nach Anspruch 1, dadurch gekennzeichnet, daß der MOS-FET (11) für einen Programmiervorgang mit einer zwischen Snapbackspannung (Vsnp) (10) und Breakdownspannung (Vb) (9) liegenden Senkenspannung betreibbar ist, bei Stromfluß durch den MOS-FET (11) zusätzlich der parasitäre bipolare Transistor geschaltet wird und der auf diese Weise leitende bipolare Transistor der Schaltstrecke des MOS-FET (11) parallelgeschaltet ist.

3. Integrierte MOS-Speicherschaltung mit einer Mehrzahl von Speicherzellen nach Anspruch 1 oder 2 für die Verwendung als programmierbarer Festwertspeicher.

4. Integrierte MOS-Speicherschaltung nach Anspruch 3, dadurch gekennzeichnet, daß mit der Senke (7) (Drain) jedes MOS-FET (11) ein Ende einer Leiterbahn (Fuse) (1) verbunden ist, daß die quellen (6) (Source) aller MOS-FETs (11) sowie die anderen Enden aller Leiterbahnen (1) mit je einer gemeinsamen Leitung (15) verbunden sind, daß zum einzelnen Ansteuern der Steuerelektroden (Gate) der MOS-FETs (11) ein Adreßdecoder (22) vorgesehen und daß die gemeinsame Leitung (15) für alle Leiterbahnen (1) (Fuses) einerseits über einen Widerstand (18) mit einem Pull-up-Element verbunden ist, wobei ein Lese-Signal von diesem Verbindungspunkt über einen Detektor (19) an ein Ausgangs-Pad (17) oder andere integrierte Schaltungsteile gelangt, und anderseits über eine Schutzstruktur (16) gegen elektrostatische Entladungen an ein Programmier-Pad angeschlossen ist.

5. Integrierte MOS-Speicherschaltung nach Anspruch 4, dadurch gekennzeichnet, daß das Pull-up-Element von einem Pull-up-Transistor (20) gebildet ist, der ebenfalls vom Adreßdecoder (22) gesteuert ist.

FIG. 1

FIG. 2

FIG. 3

FIG. 4

FIG. 5

**Europäisches Patentamt**

# EUROPÄISCHER RECHERCHENBERICHT

Nummer der Anmeldung

EP 91 89 0107

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 320 321 (SGS-THOMSON) * Zusammenfassung; Spalte 1, Zeilen 3-37; Figur 3 * | 1,3 | H 01 L 23/525 G 11 C 17/00 |
| Y | | 4,5 | |
| | --- | | |
| X | PATENT ABSTRACTS OF JAPAN, Band 13, Nr. 132 (E-736), 31. März 1989; & JP-A-63 299 139 (NEC) 06-12-1988 * Ganzes Dokument * | 1-3 | |
| | --- | | |
| X | US-A-4 605 872 (RUNG) * Zusammenfassung; Spalte 4, Zeile 15 - Spalte 6, Zeile 22; Spalte 2, Zeile 6 - Spalte 3, Zeile 13 * | 1,3 | |
| | --- | | |
| Y | EP-A-0 275 752 (SGS-THOMSON) * Figur 3; Spalte 3, Zeilen 50-56; Zusammenfassung * | 4,5 | |
| | --- | | |
| A | PATENT ABSTRACTS OF JAPAN, Band 11, Nr. 329 (E-552), 27. Oktober 1987; & JP-A-62 117 363 (FUJITSU) 28-05-1987 * Zusammenfassung; Figuren 2-3 * | 4 | RECHERCHIERTE SACHGEBIETE (Int. Cl.5) H 01 L G 11 C |
| | ----- | | |

Der vorliegende Recherchenbericht wurde für alle Patentansprüche erstellt

| Recherchenort | Abschlußdatum der Recherche | Prüfer |
|---|---|---|
| DEN HAAG | 14-08-1991 | GREENE S.K. |

EPO FORM 1503 03.82 (P0403)

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
......................................................
& : Mitglied der gleichen Patentfamilie, übereinstimmendes Dokument